(19) Europäisches Patentamt / European Patent Office / Office européen des brevets

(11) **EP 3 555 645 B1**

(12) **FASCICULE DE BREVET EUROPEEN**

(45) Date de publication et mention de la délivrance du brevet:
**29.03.2023 Bulletin 2023/13**

(21) Numéro de dépôt: **17807890.3**

(22) Date de dépôt: **06.12.2017**

(51) Classification Internationale des Brevets (IPC):
*G01R 31/08* (2006.01)    *G01R 31/11* (2006.01)
*G06F 17/15* (2006.01)

(52) Classification Coopérative des Brevets (CPC):
**G01R 31/088;** G01R 31/11; G06F 17/15

(86) Numéro de dépôt international:
**PCT/EP2017/081631**

(87) Numéro de publication internationale:
**WO 2018/108657 (21.06.2018 Gazette 2018/25)**

(54) **PROCEDE DE CALCUL D'UN REFLECTOGRAMME POUR L'ANALYSE DE DEFAUTS DANS UNE LIGNE DE TRANSMISSION**

VERFAHREN ZUR BERECHNUNG EINES REFLEKTOGRAMMS ZUR ANALYSE VON FEHLERN IN EINER ÜBERTRAGUNGSLEITUNG

METHOD FOR CALCULATING A REFLECTOGRAM TO ANALYSE FAULTS IN A TRANSMISSION LINE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.12.2016 FR 1662396**

(43) Date de publication de la demande:
**23.10.2019 Bulletin 2019/43**

(73) Titulaire: **Commissariat à l'Énergie Atomique et aux Énergies Alternatives**
**75015 Paris (FR)**

(72) Inventeur: **AUZANNEAU, Fabrice**
**91300 Massy (FR)**

(74) Mandataire: **Atout PI Laplace**
**Immeuble "Visium"**
**22, avenue Aristide Briand**
**94117 Arcueil Cedex (FR)**

(56) Documents cités:
EP-A1- 0 885 500    EP-A2- 1 209 817
FR-A5- 2 248 759    GB-A- 1 341 603
US-A- 3 646 334    US-A1- 2016 266 194

- FABRICE AUZANNEAU ET AL: "Chaos Time Domain Reflectometry for Online Defect Detection in Noisy Wired Networks", IEEE SENSORS JOURNAL., vol. 16, no. 22, 15 novembre 2016 (2016-11-15), pages 8027-8034, XP055405025, US ISSN: 1530-437X, DOI: 10.1109/JSEN.2016.2606567
- AUZANNEAU F: "Chaos time-domain reflectometry for distributed diagnosis of complex topology wired networks", ELECTRONICS LET, IEE STEVENAGE, GB, vol. 52, no. 4, 18 février 2016 (2016-02-18), pages 280-281, XP006055384, ISSN: 0013-5194, DOI: 10.1049/EL.2015.3456

**Description**

L'invention concerne le domaine de l'analyse de défauts impactant des lignes de transmission, tels que des câbles électriques.

Plus précisément, l'invention concerne le domaine particulier de la réflectométrie appliquée au diagnostic filaire qui englobe le domaine de la détection, la localisation et la caractérisation de défauts dans des lignes de transmission simples ou des réseaux filaires complexes.

Les méthodes de réflectométrie connues fonctionnent selon le procédé suivant. Un signal de référence maitrisé, par exemple un signal impulsionnel ou encore un signal multi-porteuses, est injecté à une extrémité du câble à tester. Plus généralement, dans les méthodes modernes de réflectométrie, le signal de référence utilisé est choisi en fonction de ses propriétés d'intercorrélation. Le signal se propage le long du câble et se réfléchit sur les singularités qu'il comporte.

Une singularité dans un câble correspond à une modification des conditions de propagation du signal dans ce câble. Elle résulte le plus souvent d'un défaut qui modifie localement l'impédance caractéristique du câble en provoquant une discontinuité dans ses paramètres électriques linéiques.

Le signal réfléchi est rétro-propagé jusqu'au point d'injection, puis est analysé par le système de réflectométrie. Le retard entre le signal injecté et le signal réfléchi permet de localiser une (ou plusieurs) singularité(s), correspondant à un défaut électrique, dans le câble. Un défaut peut résulter d'un court circuit, d'un circuit ouvert ou encore d'une dégradation locale du câble voire d'un simple pincement du câble.

Le traitement le plus important et également le plus coûteux en temps de calcul dans un processus de réflectométrie concerne le calcul d'un réflectogramme qui est le résultat de l'intercorrélation entre une copie du signal de test injecté dans le câble ou réseau de câbles et une mesure de ce même signal après sa propagation dans le câble ou réseau de câbles.

L'invention porte sur un procédé particulier de calcul d'un tel réflectogramme permettant de diminuer le temps de calcul nécessaire à son exécution et ainsi diminuer sa complexité de mise en oeuvre.

L'invention s'applique à tout type de câble électrique, en particulier des câbles de transmission d'énergie, dans des installations fixes ou mobiles. Les câbles concernés peuvent être coaxiaux, bifilaires, en lignes parallèles, en paires torsadées ou autre.

Les câbles sont omniprésents dans tous les systèmes électriques, pour l'alimentation ou la transmission d'information. Ces câbles sont soumis aux mêmes contraintes que les systèmes qu'ils relient et peuvent être sujets à des défaillances. Il est donc nécessaire de pouvoir analyser leur état et d'apporter des informations sur la détection de défauts, mais aussi leur localisation et leur type, afin d'aider à la maintenance.

Les méthodes de réflectométrie usuelles permettent ce type de tests. Elles utilisent des signaux de test ou référence, appelés aussi signaux de sonde ou signaux de réflectométrie. La forme de ces signaux change significativement lors de leur propagation aller-retour dans un câble, ces changements étant la conséquence des phénomènes physiques d'atténuation et de dispersion.

Les méthodes de réflectométrie utilisent un principe proche de celui du radar: un signal électrique, le signal de sonde, souvent de haute fréquence ou large bande, est injecté en un ou plusieurs endroits du câble ou du réseau de câbles à tester. Le signal se propage dans le câble ou le réseau et renvoie une partie de son énergie lorsqu'il rencontre une discontinuité électrique. Une discontinuité électrique peut résulter, par exemple, d'un branchement, de la fin du câble ou d'un défaut électrique à un endroit quelconque du câble. L'analyse des signaux renvoyés au point d'injection permet d'en déduire des informations sur la présence et la localisation de ces discontinuités, donc des défauts éventuels. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ». En particulier, les méthodes de réflectométrie temporelle TDR réalisent une analyse du signal mesuré en effectuant un calcul d'intercorrélation entre ce signal mesuré et le signal injecté pour plusieurs valeurs temporelles. Le résultat de ce calcul est appelé réflectogramme temporel. L'analyse des pics d'amplitude du réflectogramme permet de caractériser la présence et la position de défauts éventuels dans le câble.

Le calcul d'un réflectogramme temporel nécessite donc d'exécuter une opération d'intercorrélation entre une copie du signal de test et une mesure du signal propagé dans le câble à tester. Ce calcul est couteux, en particulier pour des applications embarquées où les ressources de calcul sont limitées, car il consiste en une somme de produits.

Une solution connue permettant de rendre le calcul d'un réflectogramme moins coûteux à exécuter consiste à utiliser les propriétés mathématiques de la transformée de Fourier. Le principe consiste à calculer le résultat d'intercorrélation comme la transformée de Fourier inverse du produit des transformées de Fourier des deux signaux. Ce type d'implémentation permet de diminuer la complexité de mise en oeuvre en passant de l'ordre de $K^2$ opérations pour un calcul standard à $K.\log_2(K)$ opérations pour le calcul par transformée de Fourier. K est le nombre d'échantillons de chaque signal ou encore la longueur de l'intercorrélation.

Cependant, le calcul par transformée de Fourier nécessite de connaitre l'ensemble des K échantillons du signal mesuré et du signal de test avant de pouvoir exécuter le calcul. Il faut donc attendre d'avoir injecté les K échantillons de signal et d'avoir mesuré les K échantillons du signal propagé dans le câble pour pouvoir calculer le réflectogramme.

En outre, il est souvent nécessaire de réaliser une moyenne de plusieurs réflectogrammes pour diminuer le bruit de mesure, donc en pratique il faut attendre une durée équivalente à N*K périodes du système d'injection et/ou du système de mesure, avec N le nombre de réflectogrammes nécessaires au calcul de moyenne.

Des méthodes de calcul de l'art antérieur sont décrites dans les documents « Chaos Time Domain Reflectometry for Online Defect Détection in Noisy Wired Networks », F. Auzanneau et al, IEEE Sensors Journal, « Chaos Time-domain reflectometry for distributed diagnosis of complex topology wired networks », F. Auzanneau, Electronics Let, lee Stevenage GB, et US 2016/266194.

L'invention propose un procédé permettant de simplifier la mise en oeuvre du calcul d'un réflectogramme et d'un réflectogramme moyenné, dans le cadre d'une méthode de réflectométrie temporelle. Ainsi, l'invention permet d'accélérer le calcul d'un réflectogramme pour améliorer la vitesse de traitement.

L'invention présente notamment l'avantage de permettre une mise en oeuvre d'une méthode de réflectométrie temporelle dans un dispositif embarqué dont les ressources de calcul sont limitées.

L'invention a pour objet un procédé, mise en oeuvre par ordinateur, de calcul d'un réflectogramme associé à une ligne de transmission comprenant les étapes de la revendication 1.

Selon un aspect particulier de l'invention, à chaque itération, le nombre dK d'échantillons de signal injectés dans le câble et le nombre d'échantillons de signal mesuré est égal à un échantillon.

Selon un aspect particulier de l'invention, le signal de référence est un signal chaotique.

Selon une variante particulière, le procédé selon l'invention comprend en outre une étape de calcul de la moyenne de plusieurs réflectogrammes calculés successivement, à des instants séparés d'un nombre d'échantillons inférieur au nombre d'échantillons K maximum sur lequel est calculée l'intercorrélation.

Selon un aspect particulier de cette variante, le nombre d'échantillons entre deux réflectogrammes successivement calculés est égal à quatre.

Selon un aspect particulier de l'invention, un réflectogramme est calculé à partir d'un nombre d'échantillons de mesure du signal de référence après sa propagation dans la ligne de transmission égal à K et d'un nombre d'échantillons de signal de référence injecté égal à 2K-1.

L'invention a également pour objet un procédé d'analyse d'une ligne de transmission comprenant les étapes du procédé de calcul d'un réflectogramme selon l'invention et une étape d'analyse du réflectogramme calculé pour identifier au moins un défaut sur la ligne de transmission.

Selon une variante de réalisation, le procédé d'analyse selon l'invention comprend une étape de génération et d'injection du signal de référence dans la ligne de transmission.

L'invention a encore pour objet un programme d'ordinateur comportant des instructions pour l'exécution du procédé selon l'invention, lorsque le programme est exécuté par un processeur.

L'invention a encore pour objet un support d'enregistrement lisible par un processeur sur lequel est enregistré un programme comportant des instructions pour l'exécution du procédé selon l'invention, lorsque le programme est exécuté par un processeur.

L'invention a encore pour objet un dispositif de calcul d'un réflectogramme associé à une ligne de transmission, comprenant des moyens de mesure d'un signal de propageant dans la ligne de transmission et des moyens de calcul conjointement configurés pour exécuter le procédé selon l'invention.

L'invention a encore pour objet un système de diagnostic d'une ligne de transmission comprenant un dispositif d'injection d'un signal de référence dans la ligne de transmission et un dispositif de calcul d'un réflectogramme selon l'invention.

D'autres caractéristiques et avantages de la présente invention apparaîtront mieux à la lecture de la description qui suit en relation aux dessins annexés qui représentent :

-   La figure 1a, un schéma d'un premier exemple d'un système de réflectométrie configuré pour mettre en oeuvre l'invention,
-   La figure 1b, un schéma d'un second exemple d'un système de réflectométrie configuré pour mettre en oeuvre l'invention,
-   La figure 2, un schéma illustrant une comparaison du signal injecté en un point du câble et du signal mesuré en un point du câble à deux instants successifs,
-   La figure 3, un organigramme détaillant les étapes de mise en oeuvre du procédé selon l'invention,
-   Les figure 4a et 4b, deux schémas illustrant le fonctionnement de l'invention pour le calcul de deux réflectogrammes déterminés à deux instants successifs.

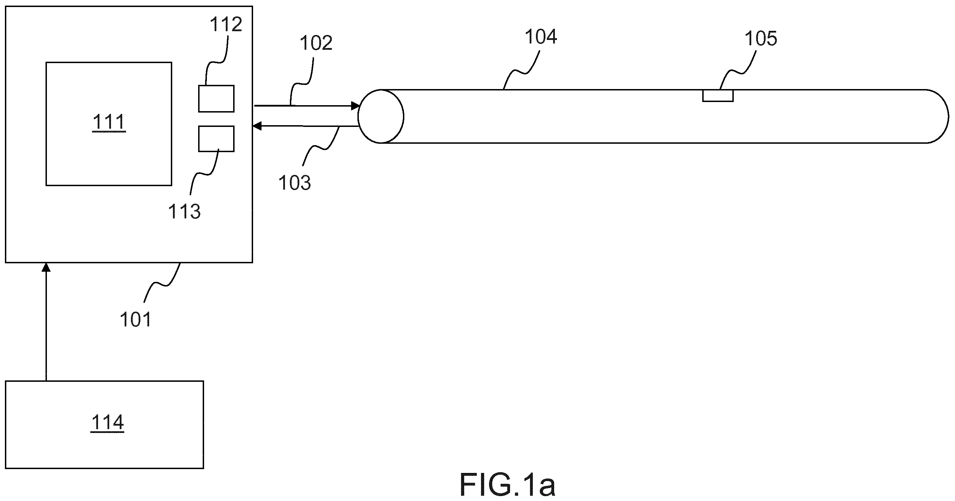

La figure 1a décrit un synoptique d'un exemple de système de réflectométrie configuré pour mettre en oeuvre l'invention. L'invention se positionne dans le contexte des méthodes de réflectométrie pour détecter, localiser ou caractériser les défauts impactant un câble ou un réseau de câble.

Sur la figure 1a, on a représenté un câble à tester 104 qui présente un défaut 105 à une distance quelconque d'une extrémité du câble. Sans sortir du cadre de l'invention, le câble 104 peut être remplacé par un réseau de câbles complexes interconnectés entre eux. Le câble simple 104 de la figure 1a est représenté dans un but purement illustratif afin d'expliciter le principe général d'une méthode de réflectométrie.

Un système de réflectométrie 101 selon l'invention comprend un composant électronique 111 de type circuit intégré, tel un circuit à logique programmable, par exemple de type FPGA, ou micro-contrôleur, adapté à exécuter deux fonctions. D'une part, le composant 111 permet de générer un signal de réflectométrie s(t) à injecter dans le câble 104 sous test. Ce signal généré numériquement est ensuite converti via un convertisseur numérique-analogique 112 puis injecté 102 à une extrémité du câble. Le signal s(t) se propage dans le câble et est réfléchi sur la singularité engendrée par le défaut 105. Le signal réfléchi est rétropropagé jusqu'au point d'injection 106 puis capturé 103, converti numériquement via un convertisseur analogique-numérique 113, et transmis au composant 111. Le composant électronique 111 est en outre adapté à exécuter les étapes du procédé selon l'invention qui sera décrit ci-après pour, à partir du signal s(t) reçu, déterminer un réflectogramme ou plusieurs réflectogrammes.

Le ou les réflectogramme(s) peuvent être transmis à une unité de traitement 114, de type ordinateur, assistant numérique personnel ou autre pour afficher les résultats des mesures sur une interface homme-machine.

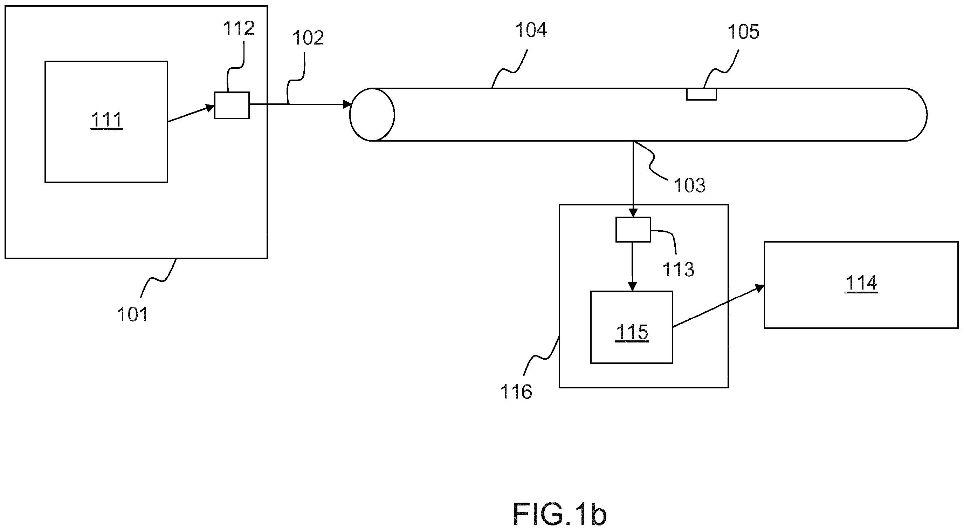

Le système 101 décrit à la figure 1 est un exemple de réalisation nullement limitatif. En particulier les deux fonctions exécutées par le composant 111 peuvent être séparées dans deux composants ou dispositifs distincts comme cela est illustré sur l'exemple de la figure 1b. Le point d'injection et le point de mesure du signal peuvent également être pris en des endroits quelconques du câble et non à son extrémité.

Sur la figure 1b, on a représenté un premier dispositif 101 dédié à la génération du signal de réflectométrie et à son injection dans le câble et un second dispositif 116 dédié à la mesure du signal en un point quelconque du câble puis au calcul du réflectogramme via un composant 115.

Le composant 115 peut être un composant électronique de type circuit intégré, tel un circuit à logique programmable, par exemple de type FPGA ou un micro-contrôleur, par exemple un processeur de signal numérique, qui reçoit les mesures de signal et est configuré pour exécuter le procédé selon l'invention. Le composant 115 comporte au moins une mémoire pour sauvegarder les derniers échantillons de signal généré et injecté dans le câble et les derniers échantillons de signal mesuré.

L'invention vise à proposer un nouveau calcul du réflectogramme qui permet de mieux répartir le grand nombre d'opérations à mettre en oeuvre par le composant 115 pour rendre le calcul plus efficace.

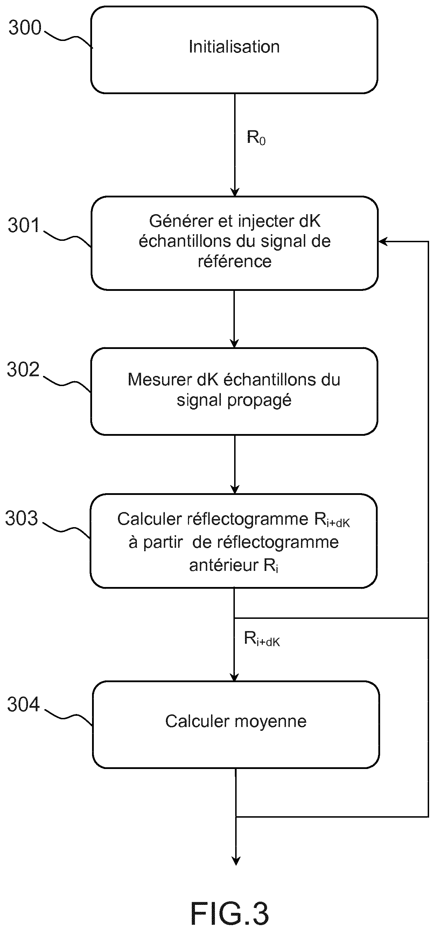

La figure 3 schématise les principales étapes du procédé de calcul d'un réflectogramme selon l'invention.

Le procédé débute par une étape d'initialisation 300 qui comprend les sous-étapes suivantes :

- Génération et injection dans le câble de K premiers échantillons du signal de référence,
- Mesure de K échantillons du signal propagé dans le câble,
- Calcul initial du réflectogramme $R_0$ à partir de l'intercorrélation entre les K échantillons du signal injecté et les K échantillons du signal mesuré.

L'étape d'initialisation 300 peut également être rendue optionnelle. Dans ce cas, le réflectogramme $R_0$ est initialisé à 0 puis, les étapes suivantes du procédé sont directement exécutées. Il faut alors attendre d'avoir mesuré K échantillons du signal propagé dans le câble pour obtenir un réflectogramme complet au profit d'un gain en temps de calcul dès le démarrage du procédé.

Le nombre K est un paramètre de l'invention et correspond à la longueur (en nombre d'échantillons) de l'intercorrélation réalisée entre le signal de référence et le signal mesuré pour calculer le réflectogramme.

La mesure du signal peut être réalisée simultanément à l'injection du signal dans le câble ou peut être réalisée avec un décalage temporel initial.

Dans le cas d'un dispositif de réflectométrie conforme à celui décrit à la figure 1b, pour lequel le dispositif de mesure 116 est distinct du dispositif d'injection 101 du signal, le dispositif de mesure 116 comprend un générateur du signal de référence qui a pour rôle de générer une copie du signal de référence injecté dans le câble par le dispositif d'injection 101. Cette copie est utilisée pour calculer le réflectogramme.

L'étape d'initialisation 300 produit un premier réflectogramme, initial, noté $R_0$.

Le procédé selon l'invention se poursuit par l'exécution itérative des étapes 301,302,303.

Les deux étapes 301,302 du procédé consistent à générer et injecter 301 dans le câble, itérativement, dK échantillons du signal de référence puis à mesurer 302 dK échantillons du signal propagé dans le câble. Le nombre dK est un paramètre de l'invention et est préférablement choisi très inférieur à la valeur de K. La valeur de dK est au moins égale à 1.

Les étapes 301 et 302 sont exécutées itérativement, autrement dit, à chaque instant i, on injecte dK échantillons de signal dans le câble et on mesure dK échantillons de signal propagé. L'injection et la mesure du signal sont faites en continu pendant toute la durée de l'analyse du câble.

Dans le cas d'un dispositif de réflectométrie conforme à celui décrit à la figure 1b, à chaque itération, une copie des dK échantillons de signal injectés dans le câble sont générés par le dispositif 116 pour être utilisés pour le calcul de réflectogramme.

A chaque instant i, correspondant à une itération, les K derniers échantillons du signal injecté et les K derniers échantillons du signal mesuré sont sauvegardés dans un buffer ou une mémoire locale en vue de réaliser un calcul d'intercorrélation sur une durée correspondant aux K derniers échantillons. On rappelle que la valeur de dK est supposée très inférieure à la valeur K. On suppose que le signal mesuré a été préalablement numérisé pour conserver des échantillons numériques.

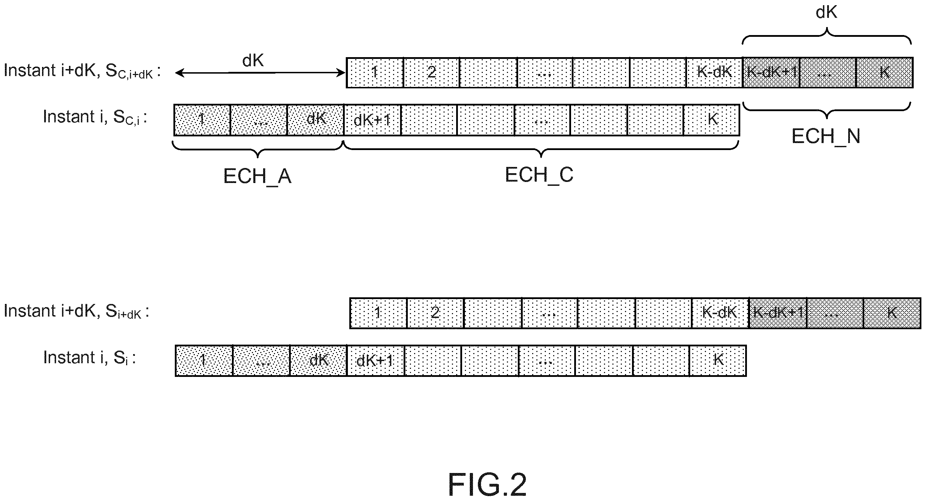

La figure 2 illustre une représentation du buffer contenant les K derniers échantillons du signal de référence d'une part et du signal mesuré d'autre part, à deux instants successifs i et i+dK. Entre ces deux instants successifs, un nombre dK de nouveaux échantillons de signal sont injectés dans le câble et le même nombre dK de nouveaux échantillons de signal sont mesurés.

Sur le haut de la figure 2, on a représenté le buffer $S_{c,i}$ contenant les échantillons du signal de référence sauvegardés à l'instant i et le buffer $S_{c,i+dK}$ contenant les échantillons du signal de référence sauvegardés à l'instant suivant i+dK.

Les dK échantillons du buffer $S_{c,i}$ les plus anciens (notés ECH-A sur la figure 2) sont supprimés du buffer $S_{c,i+dK}$ à l'instant suivant i+dK. Les K-dK échantillons du buffer $S_{c,i}$ les plus récents (notés ECH-C sur la figure 2) sont décalés dans le buffer $S_{c,i+dK}$ à l'instant suivant i+dK. Enfin, le buffer $S_{c,i+dK}$ contient dK nouveaux échantillons (notés ECH-N sur la figure 2) à l'instant suivant i+dK.

Sur le bas de la figure 2, on a représenté, de la même façon, le buffer $S_i$ contenant les échantillons du signal mesuré, sauvegardés à l'instant i et le buffer $S_{i+dK}$ contenant les échantillons du signal mesuré, sauvegardés à l'instant suivant i+dK.

La figure 2 permet d'observer qu'à deux instants successifs i et i+dK, le buffer contenant les K derniers échantillons du signal de référence présente K-dK valeurs identiques. De même à deux instants successifs i et i+dK, le buffer contenant les K derniers échantillons du signal mesuré présente également K-dK valeurs identiques.

Une valeur $R_i(n)$ du réflectogramme $R_i$ à l'instant i correspond à l'intercorrélation entre les échantillons du buffer $S_{c,i}$ contenant les K derniers échantillons du signal de référence et les échantillons du buffer $S_i$ contenant les K derniers échantillons du signal mesuré. Ce calcul est donné par la relation (1) ci-dessous.

$$R_i(n) = (S_c * S)_i(n) = \sum_{j=1}^{K-n+1} S_{c,i}(j).S_i(n+j-1) \qquad (1)$$

L'indice n varie sur l'ensemble des valeurs temporelles pour lesquelles le réflectogramme $R_i$ est calculé. La relation (1) donne donc une valeur du réflectogramme $R_i$ pour un instant temporel d'indice n.

Pour générer un réflectogramme complet, il faut exécuter la relation (1) en faisant varier l'indice n sur l'ensemble de l'intervalle temporel correspondant à la durée du réflectogramme. Ainsi l'indice n varie de 1 à K.

La valeur d'indice n du réflectogramme $R_i$ calculé à l'instant i peut être décomposée en deux sommes, à partir de la relation (1) qui devient la relation (2) :

$$R_i(n) = \sum_{j=1}^{dK} S_{c,i}(j).S_i(n+j-1) + \sum_{j=dK+1}^{K-n+1} S_{c,i}(j).S_i(n+j-1) \qquad (2)$$

De la même façon, la valeur d'indice n du réflectogramme $R_{i+dK}$ calculé à l'instant i+dK peut être décomposée en deux sommes tel qu'illustré par la relation (3) :

$$R_{i+dK}(n)$$
$$= \sum_{j=1}^{K-n-dK+1} S_{c,i+dK}(j).S_{i+dK}(n+j-1) + \sum_{j=K-n-dK+2}^{K-n+1} S_{c,i+dK}(j).S_{i+dK}(n+j-1)$$
$$(3)$$

D'après l'illustration de la figure 2, on sait que les valeurs ECH_C des échantillons du signal de référence $S_c$ mémorisé à l'instant i+dK, allant des indices 1 à K-dK sont identiques aux valeurs des échantillons du signal de référence $S_c$ mémorisé à l'instant i, allant des indices dK+1 à K. La même conclusion s'applique pour le signal mesuré S.

A partir de ces constatations et des relations (2) et (3) on peut en déduire la relation de récurrence (4) entre une valeur du réflectogramme calculé à l'instant i et la même valeur d'indice n du réflectogramme calculé à l'instant suivant i+dK :

$$R_{i+dK}(n) = R_i(n)$$

$$- \sum_{j=1}^{dK} S_{c,i}(j).S_i(n+j-1)$$

$$+ \sum_{j=K-n-dK+2}^{K-n+1} S_{c,i+dK}(j).S_{i+dK}(n+j-1) \quad (4)$$

Ainsi, les valeurs du réflectogramme à un instant i+dK sont déterminées à partir des valeurs du réflectogramme à un instant i précédent à l'étape 303 du procédé selon l'invention.

L'étape 303 consiste ainsi à retrancher au réflectogramme précédent $R_i$, les produits de corrélation entre les dK échantillons du signal mesurés à l'instant précédent i et un nombre dK d'échantillons correspondants du signal de référence injectés dans la ligne de transmission à l'instant i, puis à ajouter au réflectogramme précédent $R_i$, les produits de corrélation entre les dK nouveaux échantillons mesurés à l'instant courant i+dK et un nombre dK d'échantillons correspondants du signal de référence injectés dans la ligne de transmission à l'instant courant i+dK.

Ainsi, le calcul du réflectogramme courant réalisé à l'étape 303 comprend un nombre d'opérations à effectuer sensiblement réduit. Un nombre d'opérations minimal est atteint pour une valeur de dK égale à 1 échantillon.

Les formules (1) à (4) sont données en considérant que l'instant d'injection de nouveaux échantillons du signal de référence dans le câble et l'instant de mesure de nouveaux échantillons du signal propagé dans le câble sont identiques et correspondent à l'indice i. Sans perte de généralité, l'instant d'injection i' et l'instant de mesure i peuvent être différents, les relations (1) à (4) peuvent alors être réécrites en remplaçant i par i' dans les expressions du signal mesuré S. L'injection du signal et sa mesure doivent cependant être synchronisées et fonctionner à un rythme d'échantillonnage identique.

Les étapes 301,302,303 sont itérées pendant une durée correspondant à la durée d'analyse du câble.

L'étape 303 est exécutée pour toutes les valeurs d'un réflectogramme. Ainsi, le calcul explicité à la relation (4) est exécuté en parallèle pour n valeurs d'un réflectogramme, correspondant à n indices temporels successifs.

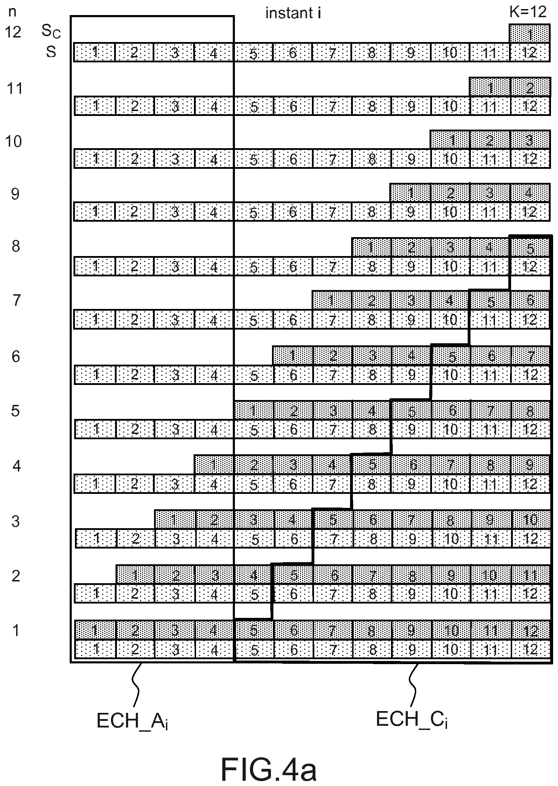

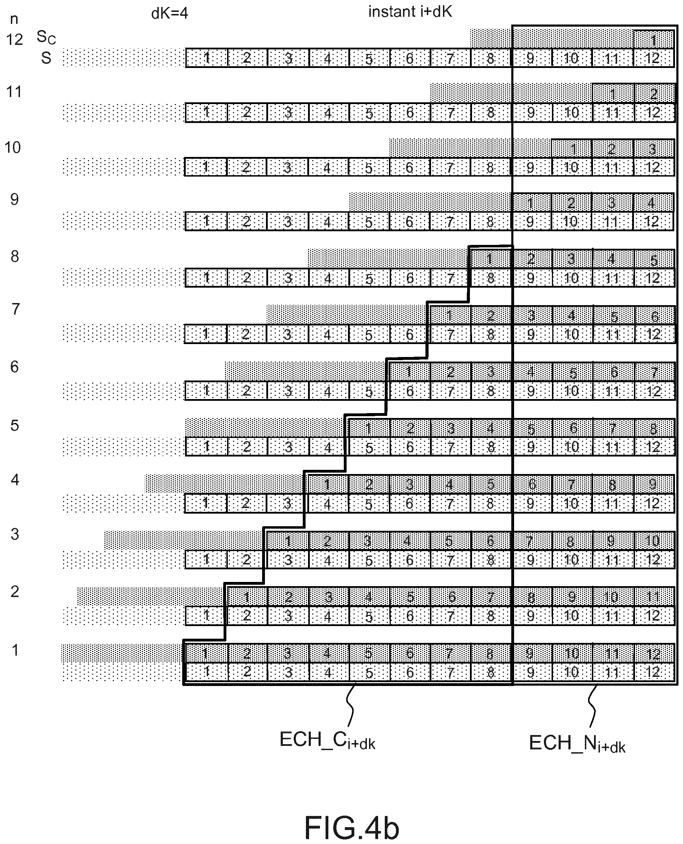

Les figures 4a et 4b illustrent ce calcul parallèle pour un réflectogramme comprenant 12 valeurs, une valeur de K égale à 12 échantillons de signal et une valeur de dK égale à 4 échantillons de signal.

Sur la figure 4a, on a représenté, pour chaque valeur d'indice n du réflectogramme $R_i(n)$ à calculer à l'instant i, le buffer Sc comprenant les K dernières valeurs du signal injecté et le buffer S comprenant les K dernières valeurs du signal mesuré. L'indice n varie de 1 à K.

Sur la figure 4b, on a représenté les mêmes buffers Sc,S pour le calcul du réflectogramme à l'instant suivant i+dK.

Chaque valeur d'un réflectogramme est obtenue en réalisant l'intercorrélation entre les K échantillons du signal S mesuré, qui sont identiques pour chaque valeur n du réflectogramme, et un nombre variable d'échantillons du signal $S_c$ de référence, ce nombre variant de 1 à K. Autrement dit, pour chaque valeur n du réflectogramme, on décale d'un échantillon les échantillons dans le buffer du signal $S_c$ de référence.

Les groupes d'échantillons en gras ECH_$C_i$ et ECH_$C_{i+dK}$ sur les deux figures 4a,4b correspondent aux échantillons de signal mesuré qui sont communs entre les instants i et i+dK. Autrement dit, il s'agit d'échantillons identiques en mémoire dans les buffers à ces deux instants successifs.

Les échantillons d'indice 9 à 12 (soit K-dK+1 à K) marqués ECH_$N_{i+dK}$ dans les buffers à l'instant i+dK correspondent aux dK nouveaux échantillons injectés dans le câble et mesurés.

Les échantillons d'indice 1 à 4 (soit 1 à dK) marqués ECH_$A_i$ dans les buffers à l'instant i correspondent aux échantillons mémorisés à l'instant i qui sont supprimés des buffers à l'instant i+dK.

Un exemple de réalisation particulier de l'invention concerne le cas où le nombre dK d'échantillons injectés puis mesurés à chaque instant i est égal à 1. Ce scénario est celui pour lequel le nombre d'opérations nécessaires à chaque itération pour calculer un réflectogramme, est le plus faible.

Pour ce mode de réalisation particulier, l'étape 303 de calcul du réflectogramme peut être simplifiée à partir de l'équation (4) de la façon suivante.

A l'instant courant i, on retranche à chaque valeur indicée n du réflectogramme $R_i(n)$, le produit $S(n)*S_c(1)$, puis on décale les échantillons dans les deux buffers S et $S_c$ d'une valeur et on enregistre dans le buffer $S_c$ le nouvel échantillon du signal de référence injecté et dans le buffer S le nouvel échantillon du signal mesuré. Enfin, on ajoute à chaque valeur indicée n du réflectogramme $R_i(n)$, le produit $S(K)*S_c(K+1-n)$.

Dans une étape 304 optionnelle, les réflectogrammes calculés à l'étape 303 peuvent être moyennés afin de lutter contre l'influence du bruit qui impacte le signal mesuré.

La moyenne $R_{moy}^n$ des réflectogrammes peut être réalisée, par exemple, en calculant itérativement une mise à jour de la moyenne courante $R_{moy}^c$ par rapport à la moyenne précédente $R_{moy}^a$ via la formule (5), où $R_i$ est le dernier réflectogramme calculé :

$$R_{moy}^n = \frac{N_{moy}R_{moy}^a + R_i}{N_{moy}+1} \quad (5)$$

$$N_{moy} = N_{moy} + 1$$

Dans une variante de réalisation, le buffer $S_c$ qui permet de sauvegarder les derniers échantillons du signal de référence injecté dans le câble, et qui sont nécessaires pour le calcul d'un réflectogramme, peut être agrandi afin de sauvegarder à chaque instant non plus K échantillons mais 2K-1. Dans ce cas, une valeur du réflectogramme est toujours calculée en réalisant l'intercorrélation entre K échantillons du buffer S comprenant le signal mesuré et K échantillons du buffer $S_c$ comprenant le signal de référence injecté. Pour chaque valeur d'indice i<n du réflectogramme, on décale les K échantillons sélectionnés pour le calcul d'un échantillon dans le buffer $S_c$.

Cette variante présente l'avantage d'améliorer la précision de calcul sur un réflectogramme du fait de la prise en compte d'une durée plus importante du signal de référence dans le calcul du réflectogramme. Ainsi, le calcul du réflectogramme selon cette variante permet de maintenir la cohérence entre les multiples copies de signal injecté contenues dans le signal mesuré et le signal avec lequel ce dernier est corrélé.

Le principe de calcul du réflectogramme mis en oeuvre à l'étape 303 reste similaire. A titre d'exemple, lorsque dK vaut 1, l'étape 303 peut être exécutée de la façon suivante.

A l'instant courant i, on retranche à chaque valeur indicée n du réflectogramme $R_i(n)$, le produit $S(1)*S_c(K+1-n)$, puis on décale les échantillons dans les deux buffers S et $S_c$ d'une valeur et on enregistre dans le buffer $S_c$ le nouvel échantillon du signal de référence injecté et dans le buffer S le nouvel échantillon du signal mesuré. Enfin, on ajoute à chaque valeur indicée n du réflectogramme $R_i(n)$, le produit $S(K)*S_c(K+1-n)$.

L'invention s'applique avantageusement pour des signaux dits chaotiques qui sont générés à l'aide d'une construction incrémentale. Autrement dit chaque échantillon $S_n$ est généré à partir de l'échantillon précédent $S_{n-1}$ : $S_n = f(S_{n-1})$.

Ce type de signal présente la particularité de permettre une injection du signal dans le câble au fil de l'eau pendant une durée importante sans nécessité de sauvegarder une quantité importante d'échantillons.

Une propriété particulière des signaux chaotiques est que l'évolution d'un réflectogramme calculé pour ces signaux est telle que la contribution du bruit varie fortement sur une durée courte. Ainsi, il est possible de moyenner des réflectogrammes calculés à des instants rapprochés et donc de mettre en oeuvre un calcul de réflectogrammes du type décrit à la figure 3. Typiquement, l'écart entre deux réflectogrammes moyennés peut être supérieur ou égal à quatre périodes d'injections d'échantillons. Un avantage de l'invention appliquée à des signaux chaotiques est qu'elle permet de réaliser un calcul de réflectogramme moyen sur une durée plus courte que les méthodes habituelles et ainsi de produire un résultat final plus rapidement.

L'invention présente également l'avantage de diminuer sensiblement l'influence du bruit sur les réflectogrammes calculés par rapport à une méthode basée sur l'emploi de transformées de Fourier.

Cet avantage peut être illustré par l'intermédiaire d'un exemple numérique. En considérant un horizon temporel correspondant à 1000 instants d'horloge (donc 1000 échantillons de signal généré, injectés dans le câble et mesurés après propagation dans le câble), et en fixant le nombre K d'échantillons utilisés pour calculer un réflectogramme à 100, une méthode basée sur l'emploi de transformées de Fourier permet de calculer 10 réflectogrammes pendant cette durée et donc de faire diminuer le bruit d'un facteur $20*\log_{10}(10) = 20$ dB après moyennage.

Au contraire, l'invention permet dans la même durée de réaliser 900/4 = 225 réflectogrammes (en prenant dK égal à 4) ce qui entraine une diminution du bruit sur le réflectogramme obtenu après moyennage d'un facteur $20*\log10(225) = 47$ dB.

Ainsi, l'invention permet de lutter efficacement contre l'influence du bruit de mesure.

Le procédé selon l'invention peut être implémenté sur le composant 115 à partir d'éléments matériels et/ou logiciels.

Le procédé selon l'invention peut être implémenté directement par un processeur embarqué ou dans un dispositif spécifique. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gate Array »). Le dispositif selon l'invention peut utiliser un ou plusieurs circuits électroniques dédiés ou un circuit à usage général. La technique de l'invention peut se réaliser sur une machine de calcul reprogrammable (un processeur ou un micro contrôleur par exemple) exécutant un programme comprenant une séquence d'instructions, ou sur une machine de calcul dédiée (par exemple un ensemble de portes logiques comme un FPGA ou un ASIC, ou tout autre module matériel).

Le procédé selon l'invention peut également être mis en oeuvre exclusivement en tant que programme d'ordinateur, le procédé étant alors appliqué à des mesures de signaux préalablement enregistrées. Dans un tel cas, l'invention peut être mise en oeuvre en tant que programme d'ordinateur comportant des instructions pour son exécution. Le programme d'ordinateur peut être enregistré sur un support d'enregistrement lisible par un processeur.

La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro logiciel, un microcode, ou toute autre forme d'instruction d'ordinateur) qui peut être utilisé pour programmer un ou plusieurs processeurs pour mettre en oeuvre des aspects des techniques décrites ici. Les moyens ou ressources informatiques peuvent notamment être distribués ("*Cloud computing*"), éventuellement selon des technologies de pair-à-pair. Le code logiciel peut être exécuté sur n'importe quel processeur approprié (par exemple, un microprocesseur) ou coeur de processeur ou un ensemble de processeurs, qu'ils soient prévus dans un dispositif de calcul unique ou répartis entre plusieurs dispositifs de calcul (par exemple tels qu'éventuellement accessibles dans l'environnement du dispositif). Le code exécutable de chaque programme permettant au dispositif programmable de mettre en oeuvre les processus selon l'invention, peut être stocké, par exemple, dans le disque dur ou en mémoire morte. De manière générale, le ou les programmes pourront être chargés dans un des moyens de stockage du dispositif avant d'être exécutés. L'unité centrale peut commander et diriger l'exécution des instructions ou portions de code logiciel du ou des programmes selon l'invention, instructions qui sont stockées dans le disque dur ou dans la mémoire morte ou bien dans les autres éléments de stockage précités.

## Revendications

1. Procédé, mise en oeuvre par ordinateur, de calcul d'un réflectogramme associé à une ligne de transmission (104) dans laquelle un signal de référence est préalablement injecté, un réflectogramme étant défini par un calcul à plusieurs instants successifs de l'intercorrélation entre le signal de référence injecté et une mesure du signal de référence après sa propagation dans la ligne de transmission calculée sur un nombre d'échantillons maximum égal à K ledit procédé comprenant les étapes suivantes exécutées itérativement:

   - Acquérir (302), à un instant courant i+dK, une mesure dudit signal après sa propagation dans la ligne de transmission, ladite mesure comprenant un nombre dK d'échantillons,
   - Déterminer (303) un réflectogramme $R_{i+dK}$ à l'instant courant i+dK, à partir d'un réflectogramme précédent $R_i$ calculé à un instant précédent i, en effectuant les opérations suivantes pour chaque valeur du réflectogramme:

      • Retrancher au réflectogramme précédent $R_i$, au moins un produit de corrélation entre un nombre dK d'échantillons du signal mesurés à l'instant précédent i et un nombre dK d'échantillons correspondants du signal de référence injectés dans la ligne de transmission à un instant d'injection i',
      • Ajouter au réflectogramme précédent $R_i$, au moins un produit de corrélation entre un nombre dK d'échantillons mesurés à l'instant courant i+dK et un nombre dK d'échantillons correspondants du signal de référence injectés dans la ligne de transmission à un instant d'injection i'+d K,
      • dK étant strictement inférieur à K

2. Procédé de calcul d'un réflectogramme selon la revendication 1 dans lequel, à chaque itération, le nombre dK d'échantillons de signal injectés dans le câble et le nombre d'échantillons de signal mesuré est égal à un échantillon.

3. Procédé de calcul d'un réflectogramme selon l'une des revendications précédentes dans lequel le signal de référence est un signal chaotique.

4. Procédé de calcul d'un réflectogramme selon la revendication 3 comprenant en outre une étape (304) de calcul de la moyenne de plusieurs réflectogrammes calculés successivement, à des instants séparés d'un nombre d'échantillons inférieur au nombre d'échantillons K maximum sur lequel est calculée l'intercorrélation.

5. Procédé de calcul d'un réflectogramme selon la revendication 4 dans lequel le nombre d'échantillons entre deux réflectogrammes successivement calculés est égal à quatre.

**6.** Procédé de calcul d'un réflectogramme selon l'une des revendications précédentes dans lequel un réflectogramme est calculé à partir d'un nombre d'échantillons de mesure du signal de référence après sa propagation dans la ligne de transmission égal à K et d'un nombre d'échantillons de signal de référence injecté égal à 2K-1.

**7.** Procédé d'analyse d'une ligne de transmission comprenant les étapes du procédé de calcul d'un réflectogramme selon l'une des revendications précédentes et une étape d'analyse du réflectogramme calculé pour identifier au moins un défaut sur la ligne de transmission.

**8.** Procédé d'analyse d'une ligne de transmission selon la revendication 7 comprenant une étape de génération et d'injection (301) du signal de référence dans la ligne de transmission.

**9.** Programme d'ordinateur comportant des instructions pour l'exécution du procédé selon l'une quelconque des revendications 1 à 7, lorsque le programme est exécuté par un processeur.

**10.** Support d'enregistrement lisible par un processeur sur lequel est enregistré un programme comportant des instructions pour l'exécution du procédé selon l'une quelconque des revendications 1 à 7, lorsque le programme est exécuté par un processeur.

**11.** Dispositif (101,116) de calcul d'un réflectogramme associé à une ligne de transmission, comprenant des moyens de mesure (113) d'un signal de référence se propageant dans la ligne de transmission et des moyens de calcul (111,115) conjointement configurés pour exécuter le procédé selon l'une quelconque des revendications 1 à 7.

**12.** Système de diagnostic d'une ligne de transmission comprenant un dispositif (101) d'injection d'un signal de référence dans la ligne de transmission et un dispositif (116) de calcul d'un réflectogramme selon la revendication 11.

**Patentansprüche**

**1.** Computerimplementiertes Verfahren zum Berechnen eines Reflektogramms, das mit einer Übertragungsleitung (104) assoziiert ist, in die zuvor ein Referenzsignal eingespeist wurde, wobei ein Reflektogramm durch eine Berechnung, zu mehreren aufeinanderfolgenden Zeitpunkten, der Interkorrelation zwischen dem eingespeisten Referenzsignal und einem Messwert des Referenzsignals nach seiner Ausbreitung in der Übertragungsleitung definiert wird, berechnet über eine maximale Anzahl K von Samples, wobei das Verfahren die folgenden iterativ ausgeführten Schritte umfasst:

- Erfassen (302), zu einem aktuellen Zeitpunkt i+dK, eines Messwerts des Signals nach seiner Ausbreitung in der Übertragungsleitung, wobei der Messwert eine Anzahl dK von Samples umfasst,
- Bestimmen (303) eines Reflektogramms $R_{i+dK}$ zum aktuellen Zeitpunkt i+dK auf der Basis eines vorherigen Reflektogramms $R_i$, das zu einem vorherigen Zeitpunkt i berechnet wurde, indem für jeden Wert des Reflektogramms die folgenden Operationen durchgeführt werden:

• Abziehen, von dem vorherigen Reflektogramm $R_i$, mindestens eines Korrelationsprodukts zwischen einer Anzahl dK von Samples des Signals, gemessen zum vorherigen Zeitpunkt i, und einer Anzahl dK von entsprechenden Samples des Referenzsignals, die zu einem Einspeisezeitpunkt i' in die Übertragungsleitung eingespeist wurden,
• Hinzufügen, zum vorherigen Reflektogramm $R_i$, mindestens eines Korrelationsprodukts zwischen einer Anzahl dK von zum aktuellen Zeitpunkt i+dK gemessenen Samples und einer Anzahl dK von entsprechenden Samples des Referenzsignals, die zum Einspeisezeitpunkt i'+dK in die Übertragungsleitung eingespeist wurden,
• wobei dK strikt kleiner als K ist.

**2.** Verfahren zum Berechnen eines Reflektogramms nach Anspruch 1, wobei bei jeder Iteration die Anzahl dK von in das Kabel eingespeisten Signalsamples und die Anzahl von gemessenen Signalsamples gleich einem Sample ist.

**3.** Verfahren zum Berechnen eines Reflektogramms nach einem der vorherigen Ansprüche, wobei das Referenzsignal ein chaotisches Signal ist.

4. Verfahren zum Berechnen eines Reflektogramms nach Anspruch 3, das ferner einen Schritt (304) des Berechnens des Mittelwerts mehrerer Reflektogramme umfasst, die nacheinander zu Zeitpunkten berechnet wurden, die um eine Anzahl von Samples voneinander getrennt sind, die kleiner ist als die maximale Anzahl K von Samples, an der die Interkorrelation berechnet wird.

5. Verfahren zum Berechnen eines Reflektogramms nach Anspruch 4, wobei die Anzahl von Samples zwischen zwei nacheinander berechneten Reflektogrammen gleich vier ist.

6. Verfahren zum Berechnen eines Reflektogramms nach einem der vorherigen Ansprüche, wobei ein Reflektogramm auf der Basis einer Anzahl K von Messsamples des Referenzsignals nach seiner Ausbreitung in der Übertragungsleitung und einer Anzahl 2K-1 von Samples des eingespeisten Referenzsignals berechnet wird.

7. Verfahren zum Analysieren einer Übertragungsleitung, das die Schritte des Verfahrens zum Berechnen eines Reflektogramms nach einem der vorherigen Ansprüche und einen Schritt des Analysierens des berechneten Reflektogramms umfasst, um mindestens einen Fehler auf der Übertragungsleitung zu identifizieren.

8. Verfahren zum Analysieren einer Übertragungsleitung nach Anspruch 7, das einen Schritt des Erzeugens und Einspeisens (301) des Referenzsignals in die Übertragungsleitung umfasst.

9. Computerprogramm, das Befehle zur Durchführung des Verfahrens nach einem der Ansprüche 1 bis 7 umfasst, wenn das Programm von einem Prozessor ausgeführt wird.

10. Prozessorlesbares Aufzeichnungsmedium, auf dem ein Programm mit Befehlen zur Durchführung des Verfahrens nach einem der Ansprüche 1 bis 7 aufgezeichnet ist, wenn das Programm von einem Prozessor ausgeführt wird.

11. Vorrichtung (101, 116) zur Berechnung eines mit einer Übertragungsleitung verbundenen Reflektogramms, das Mittel zur Messung (113) eines sich in der Übertragungsleitung ausbreitenden Referenzsignals und Berechnungsmittel (111, 115) umfasst, die gemeinsam zur Durchführung des Verfahrens nach einem der Ansprüche 1 bis 7 konfiguriert sind.

12. System zur Diagnose einer Übertragungsleitung, das eine Vorrichtung (101) zur Einspeisung eines Referenzsignals in die Übertragungsleitung und eine Vorrichtung (116) zur Berechnung eines Reflektogramms nach Anspruch 11 umfasst.

**Claims**

1. A computer-implemented method for calculating a reflectogram associated with a transmission line (104) in which a reference signal is injected beforehand, a reflectogram being defined by a calculation, at multiple successive times, of the intercorrelation between the injected reference signal and a measurement of the reference signal after propagation thereof in the transmission line, calculated on a maximum number of samples equal to K, said method comprising the following iteratively executed steps:

   - acquiring (302), at a current time i+dK, a measurement of said signal after propagation thereof in the transmission line, said measurement comprising a number dK of samples,
   - determining (303) a reflectogram $R_{i+dK}$ at the current time i+dK, from a previous reflectogram $R_i$ calculated at a previous time i, by performing the following operations for each value of the reflectogram:

      • subtracting, from the previous reflectogram $R_i$, at least one product of correlation between a number dK of samples of the signal that are measured at the previous time i and a number dK of corresponding samples of the reference signal that are injected into the transmission line at an injection time i',
      • adding, to the previous reflectogram $R_i$, at least one product of correlation between a number dK of samples measured at the current time i+dK and a number dK of corresponding samples of the reference signal that are injected into the transmission line at an injection time i'+dK,
      • dK being strictly less than K.

2. The method for calculating a reflectogram according to claim 1, wherein, at each iteration, the number dK of signal samples injected into the cable and the number of measured signal samples is equal to one sample.

3. The method for calculating a reflectogram according to one of the preceding claims, wherein the reference signal is a chaotic signal.

4. The method for calculating a reflectogram according to claim 3, further comprising a step (304) of calculating the average of multiple reflectograms calculated successively, at times separated by a number of samples lower than the maximum number of samples K on which the intercorrelation is calculated.

5. The method for calculating a reflectogram according to claim 4, wherein the number of samples between two successively calculated reflectograms is equal to four.

6. The method for calculating a reflectogram according to one of the preceding claims, wherein a reflectogram is calculated from a number of measured samples of the reference signal after propagation thereof in the transmission line equal to K and from a number of injected reference signal samples equal to 2K-1.

7. A method for analysing a transmission line, comprising the steps of the method for calculating a reflectogram according to one of the preceding claims and a step of analysing the calculated reflectogram in order to identify at least one fault on the transmission line.

8. The method for analysing a transmission line according to claim 7, comprising a step of generating and of injecting (301) the reference signal into the transmission line.

9. A computer program containing instructions for executing the method according to any one of claims 1 to 7 when the program is executed by a processor.

10. A recording medium able to be read by a processor and on which there is recorded a program containing instructions for executing the method according to any one of claims 1 to 7 when the program is executed by a processor.

11. A device (101, 116) for calculating a reflectogram associated with a transmission line, comprising means (113) for measuring a reference signal propagating in the transmission line and calculating means (111, 115) that are jointly configured so as to execute the method according to any one of claims 1 to 7.

12. A system for diagnosing a transmission line, comprising a device (101) for injecting a reference signal into the transmission line and a device (116) for calculating a reflectogram according to claim 11.

FIG.1a

FIG.1b

EP 3 555 645 B1

EP 3 555 645 B1

Instant i+dK, $S_{C,i+dK}$ :

| 1 | 2 | .. | | | K-dK | K-dK+1 | ... | K |

Instant i, $S_{C,i}$ :

| 1 | .. | dK | dK+1 | | .. | | | K |

dK

ECH_A

ECH_C

ECH_N

dK

Instant i+dK, $S_{i+dK}$ :

| 1 | 2 | .. | | | K-dK | K-dK+1 | ... | K |

Instant i, $S_i$ :

| 1 | .. | dK | dK+1 | | .. | | | K |

# FIG.2

300 — Initialisation

$R_0$

301 — Générer et injecter dK échantillons du signal de référence

302 — Mesurer dK échantillons du signal propagé

303 — Calculer réflectogramme $R_{i+dK}$ à partir de réflectogramme antérieur $R_i$

$R_{i+dK}$

304 — Calculer moyenne

FIG.3

FIG.4a

FIG.4b

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2016266194 A

**Littérature non-brevet citée dans la description**

- **F. AUZANNEAU et al.** Chaos Time Domain Reflectometry for Online Defect Détection in Noisy Wired Networks. *IEEE Sensors Journal*

- **F. AUZANNEAU.** Chaos Time-domain reflectometry for distributed diagnosis of complex topology wired networks. *Electronics Let, lee Stevenage GB*